Europäisches Patentamt

European Patent Office

Office européen des brevets

(11) Veröffentlichungsnummer: **0 248 266**
**A2**

(12) # EUROPÄISCHE PATENTANMELDUNG

(21) Anmeldenummer: **87107286.4**

(51) Int. Cl.⁴: **H01L 23/52** , H03K 19/003

(22) Anmeldetag: **19.05.87**

(30) Priorität: **06.06.86 DE 3619022**

(43) Veröffentlichungstag der Anmeldung:
**09.12.87 Patentblatt 87/50**

(84) Benannte Vertragsstaaten:
**AT DE FR GB IT NL**

(71) Anmelder: **Siemens Aktiengesellschaft Berlin und München**
**Wittelsbacherplatz 2**
**D-8000 München 2(DE)**

(72) Erfinder: **Köppe, Siegmar, Dipl.-Ing.**
**Am Kamp 18**
**D-3014 Laatzen(DE)**

(54) **Logikschaltung mit einer Mehrzahl von zueinander komplementären Feldeffekttransistoren.**

(57) Logikschaltung bei der jeweils zwei oder mehrere, insbesondere zueinander komplementäre Feldeffekttransistoren (T3, T1) über einen Eingang (E1) mit demselben Eingangssignal angesteuert werden. Für diese Transistoren ist eine mit dem Eingang (E1) verbundene, verzweigungsfrei ausgebildete Gateleitung (9) vorgesehen, wobei die Gateelektroden durch im Abstand voneinander angeordnete Abschnitte der Gateleitung (9) gebildet werden.

FIG 2

EP 0 248 266 A2

## Logikschaltung mit einer Mehrzahl von zueinander komplementären Feldeffekttransistoren

Die Erfindung bezieht sich auf eine Logikschaltung mit einer Mehrzahl von auf einem dotierten Halbleiterkörper integrierten, zueinander komplementären Feldeffekttransistoren nach dem Oberbegriff des Patentanspruchs 1.

Bei solchen Schaltungen, mit denen beispielsweise Gatterfunktionen der logischen Schaltkreistechnik realisiert werden, besteht die Schwierigkeit, daß ein Unterbrechungsfehler (stuck-open-fault) in der Gateleitung eines Feldeffekttransistors mittels eines der üblichen Verfahren zur automatischen Fehlererkennung schwer festzustellen ist. Diese Verfahren beruhen im einzelnen darauf, daß den Eingängen einer zu prüfenden Schaltung eine Folge von Test-Bitmustern zugeführt wird, von denen wenigstens eines so beschaffen ist, daß es für die Erkennung eines bestimmten Schaltungsfehlers geeignet ist, d.h. zu einem an den Schaltungsausgängen abgreifbaren Ausgangsbitmuster führt, das von dem bei Fehlerfreiheit zu erwartenden ausgangsseitigen Sollmuster in wenigstens einem Bit abweicht.

Ein Unterbrechungsfehler in der Gateleitung eines Feldeffekttransistors ist für die Fehlererkennung deswegen sehr problematisch, weil kein eindeutiges Modell für die Fehlersimulation bereitgestellt werden kann. Der Grund hierfür liegt darin, daß das Verhalten des betreffenden Feldeffekttransistors von der jeweiligen Ladung bzw. dem Potential auf seiner sich in einem "floatenden" Zustand befindenden Gateelektrode abhängig ist. Dieses Potential ist aber unbekannt. Selbst unter der Annahme, daß das Potential auf dem "floatenden" Gate unterhalb der Einstzspannung des Feldeffekttransistors liegt und dieser Fehler als Unterbrechungsfehler behandelt werden kann, ergeben sich große Probleme bei der Fehlererkennung, wenn der betreffende Feldeffekttransistor in einem Schaltungszweig liegt, der anderen entsprechend aufgebauten Schaltungszweigen parallel geschaltet ist. Bei der Fehlererkennung genügt es dann nämlich nicht, den Schaltungseingängen ein Bitmuster zuzuführen, das diesem Fehler individuell zugeordnet ist. Vielmehr muß die Schaltung vorher durch Anlegen eines Initialisierungsmusters in einen Vorbereitungszustand versetzt werden, der diesem Fehler ebenfalls individuell zugeordnet ist. Da beim Anlegen eines Test-Bitmusters, das von dem individuell zugeordneten Test-Bitmuster abweicht, der Vorbereitungszustand wieder aufgehoben werden kann, müssen ganze Sequenzen von jeweils einem Initialisierungs-Bitmuster und einem unmittelbar darauffolgenden Test-Bitmuster an die Schaltungseingänge gelegt werden, um die parallelen Schaltungszweige einzeln nacheinander auf das Vorliegen von Unterbrechungsfehlern untersuchen zu können.

Unterbrechungsfehler in der Gateleitung eines Feldeffekttransistors sind im wesentlichen durch das Abreißen von Leiterbahnen an den Kanten der Feldoxidschicht und durch die Ablagerung von verunreinigenden Partikeln bei der Schaltungsherstellung bedingt. Dabei treten diese Probleme mit fortschreitender Verkleinerung der Schaltungsstrukturen in zunehmendem Maße in Erscheinung.

Der Erfindung liegt die Aufgabe zugrunde, eine Schaltung der eingangs genannten Art anzugeben, die hinsichtlich des Vorliegens von Unterbrechungsfehlern in den Gateleitungen der Feldeffekttransistoren in wesentlich einfa cherer Weise überprüft werden kann, als das bisher möglich war. Das wird erfindungsgemäß durch eine Ausbildung nach dem kennzeichnenden Teil des Patentanspruchs 1 erreicht.

Der mit der Erfindung erzielbare Vorteil besteht insbesondere darin, daß durch die Anwendung einer verzweigungsfrei ausgebildeten Gateleitung, die allen über einen Schaltungseingang anzusteuernden Feldeffekttransistoren gemeinsam ist, ein Unterbrechungsfehler in dem Teil der Gateleitung, der zwischen dem Schaltungseingang und der ihm am nächsten liegenden Gateelektrode eines ersten Feldeffekttransistors liegt, sich auf alle Feldeffekttransistoren, die über diesen Schaltungseingang anzusteuern sind, in gleicher Weise auswirkt. Damit entspricht ein solcher Fehler einem Haftfehler (stuck-at-fault) am Schaltungseingang, der bei Anwendung der üblichen Verfahren der Fehlersimulation und Fehlererkennung keine besonderen Schwierigkeiten bereitet. Es verbleibt lediglich die Überprüfung, ob ein Unterbrechungsfehler in den Teilen der Gateleitung vorhanden ist, die die einzelnen über den Schaltungseingang anzusteuernden Feldeffekttransistoren miteinander verbinden. Falls es sich dabei z.B. um zwei Transistoren handelt, wirkt sich ein solcher Fehler nur auf den weiter vom Eingang entfernten Transistor aus. Auch für den Fall, daß dieser einem anderen Feldeffekttransistor unmittelbar parallel geschaltet ist, braucht die dann relativ schwierige Fehlersimulation und Fehlererkennung bezüglich eines Unterbrechungsfehlers eben nur noch für den weiter vom Eingang entfernten Transistor durchgeführt werden. Bei einer Weiterbildung der Erfindung nach Patentanspruch 2, nach der der weiter vom Eingang entfernte Feldeffekttransistor einem anderen Feldeffekttransistor nicht unmittelbar parallel geschaltet ist, sondern zu einem solchen unmittelbar in Serie liegt, wirkt sich ein Unterbrechungsfehler in dem beide mit einander verbinden den Teil der Gateleitung nur noch als Unterbrechungsfehler in einem Schaltungszweig mit seriell zueinander angeordneten Feldeffekttransistoren aus. Derartige Unterbrechungsfehler sind aber relativ einfach zu erkennen. Daher wird durch die Erfindung eine deutliche Erhöhung der Testbarkeit einer Logikschaltung bei einer gleichzeitigen Aufwandsreduktion erreicht.

Der Anspruch 3 stellt eine bevorzugte Ausbildung der Logikschaltung nach der Erfindung dar.

Die Erfindung wird nachfolgend anhand der Zeichnung näher erläutert. Dabei zeigt:

Fig. 1 die Prinzipschaltung eines an sich bekannten NAND-Gatters mit zwei Eingängen,

Fig. 2 ein nach der Erfindung ausgebildetes NAND-Gatter mit zwei Eingängen in Draufsicht und

Fig. 3 ein weiteres nach der Erfindung ausgebildetes NAND-Gatter mit zwei Eingängen.

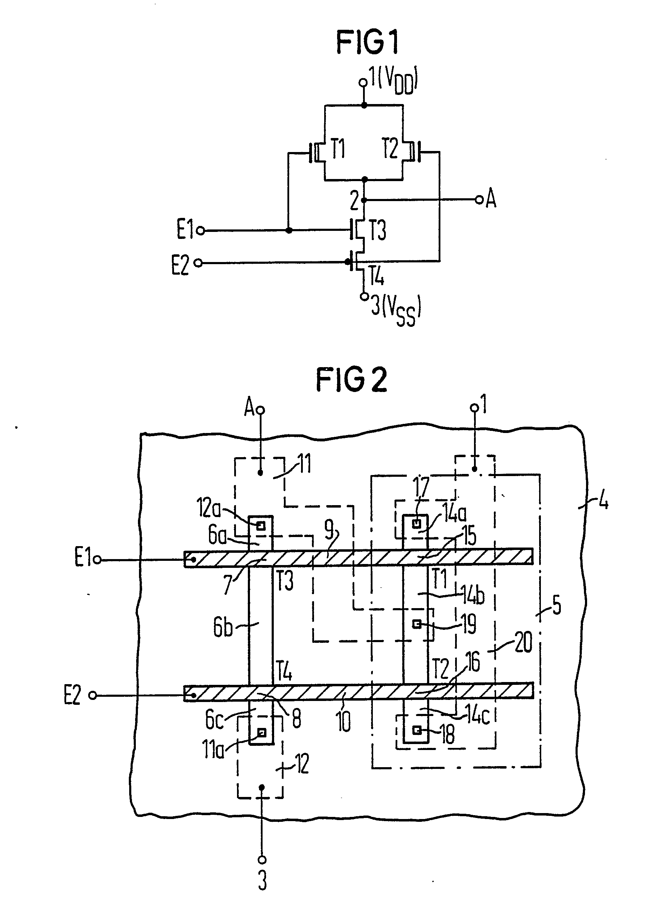

Das in Fig. 1 dargestellte, in komplementärer Schaltkreistechnik ausgebildete NAND-Gatter weist zwei mit ihren Source-Drain-Strecken einander parallel geschaltete p-Kanal-Feldeffekttransistoren T1 und T2 auf. Die Sourceanschlüsse beider Transistoren liegen an einem Anschluß 1, der mit der Versorgungsspannung $V_{DD}$ beschaltet ist, während die Drainanschlüsse mit einem Schaltungspunkt 2 verbunden sind. Dieser ist einerseits mit dem Gatterausgang A und andererseits über die Serienschaltung zweier n-Kanal-Feldeffekttransistoren T3 und T4 mit einem auf Bezugspotential $V_{SS}$ liegenden Anschluß 3 verbunden. Die Gateelektroden von T1 und T3 sind mit einem Schaltungseingang E1 beschaltet, die Gateelektroden von T2 und T4 mit einem Schaltungseingang E2.

Fig. 2 zeigt eine erfindungsgemäß ausgebildete, die NAND-Funktion nach Fig. 1 realisierende Logikschaltung in Draufsicht. Dabei ist ein dotierter Halbleiterkörper 4, z.B. aus p-leitendem Silizium, mit einer n-leitenden Wanne 5 versehen, die sich bis zu der in Fig. 2 sichtbaren Grenzfläche von 4 erstreckt und in lateraler Richtung durch eine strichpunktierte Linie begrenzt wird. In den Halbleiterkörper 4 sind n-leitende Zonen 6a, 6b und 6c eingefügt. Zwischen 6a und 6b befindet sich ein p-leitendes Teilgebiet 7 des Halbleiterkörpers 4, zwischen 6b und 6c ein weiteres p-leitendes Teilgebiet 8 von 4. Ein Streifen 9 aus polykristallinem Silizium, der durch eine dünne, elektrisch isolierende Schicht von der sichtbaren Grenzfläche des Halbleiterkörpers 4 getrennt ist, bildet eine Gateleitung, die mit einem Anschluß versehen ist, der dem Schaltungseingang E1 von Fig. 1 entspricht. Das Teilgebiet 7 stellt das Kanalgebiet von T3 dar, der das Teilgebiet 7 überdeckende Abschnitt des Streifens 9 die Gateelektrode und die Zone 6a und 6b jeweils das Source-und Draingebiet dieses Transistors.

Die Zonen 6b und 6c stellen das Draingebiet und das Sourcegebiet des Transistors T4 dar, wobei das Teilgebiet 8 das Kanalgebiet dieses Transistors bildet. Seine Gateelektrode besteht aus dem das Teilgebiet 8 überdeckenden Abschnitt eines weiteren Streifens 10 aus polykristallinem Silizium, der ebenfalls durch eine elektrisch isolierende Schicht von der sichtbaren Grenzfläche des Halbleiterkörpers 4 getrennt ist und einen Anschluß aufweist, der dem Schaltungseingang E2 entspricht. Oberhalb der Streifen 9 und 10 ist eine elektrisch isolierende Zwischenschicht vorgesehen, auf der leitende Belegungen 11 und 12 angeordnet sind. Die leitende Belegung 11 kontaktiert im Bereich eines in dieser isolierenden Zwischenschicht und der genannten isolierenden Schicht vorgesehenen Kontaktlochs 12a die Zone 6a. Im Bereich eines weiteren, sowohl in die isolierende Zwischenschicht als auch in die isolierende Schicht eingefügten Kontaktloches 11a kontaktiert die leitende Belegung 12 die Zone 6c. Dabei ist die leitende Belegung mit einem Anschluß versehen, der dem Gatterausgang A von Fig. 1 entspricht. Die leitende Belegung 12 weist einen Anschluß auf, der dem mit Bezugspotential beschalteten Anschluß 3 entspricht.

In die n-leitende Wanne 5 sind drei p-leitende Zonen 14a, 14b und 14c eingefügt. Zwischen 14a und 14b befindet sich ein n-leitendes Teilgebiet 15 der Wanne 5, zwischen 14b und 14c ein weiteres n-leitendes Teilgebiet 16 derselben. Das Teilgebiet 15 stellt das Kanalgebiet von T1 dar, der das Teilgebiet 15 überdeckende Abschnitt des Streifens 9 die Gateelektrode und die Zonen 14a und 14b jeweils das Sourcegebiet und das Draingebiet dieses Transistors. In analoger Weise bildet das n-leitende Teilgebiet 16 der Wanne 5 das Kanalgebiet von T2, der das Teilgebiet 16 überdeckende Abschnitt des Streifens 10 die Gateelektrode und die Zonen 14b und und 14c jeweils das Draingebiet und das Sourcegebiet dieses Transistors. In der elektrisch isolierenden Zwischenschicht und in der elektrisch isolierenden Schicht sind Kontaktlöcher 17 und 18 vorgesehen, in der elektrisch isolierenden Zwischenschicht ein Kontaktloch 19. Im Bereich der Kontaktlöcher 17 und 18 werden die Zonen 14a und 14c von einer leitenden Belegung 20 kontaktiert, die mit einem Anschluß versehen ist, der dem Anschluß 1 von Fig. 1 entspricht. Im Bereich des Kontaktloches 19 wird die Zone 14b von der leitenden Belegung 11 kontaktiert.

Die Transistoren T1 und T3 werden in Fig. 2 durch die verzweigungsfrei ausgeführte Gateleitung 9, die mit dem Schaltungseingang E1 beschaltet ist, angesteuert. Ist nun ein Unterbrechungsfehler in dem zwischen dem Schaltungseingang E1 und dem Transistor T3 liegenden Teil der Gateleitung 9 vorhanden, so wirkt sich dieser Fehler auf die beiden über 9 anzusteuernden Transistoren T3 und T1 in gleicher Weise aus. Bei beiden Transistoren liegt an der Gateelektrode jeweils das gleiche unbekannte Potential an. Dieses wird entweder als eine logische "0" oder eine logische "1" bewertet, was einem Haftfehler (stuck-at-fault) am Gattereingang E1 entspricht.

Die gleiche Aufwandsreduktion ergibt sich auch bei der Überprüfung der Gateleitung 10, über die die Transistoren T4 und T2 angesteuert werden, auf das Vorliegen von Unterbrechungsfehlern.

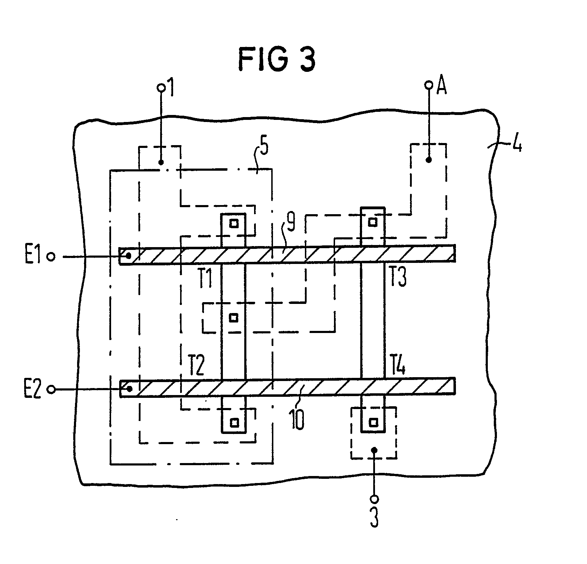

Fig. 3 unterscheidet sich von Fig. 2 lediglich dadurch, daß sich der die Transistoren T3 und T4 enthaltende Schaltungsteil rechts von dem die Transistoren T1 und T2 enthaltenden Schaltungsteil befindet, also gegenüber der Anordnung dieser Schaltungsteile in Fig. 2 seitenverkehrt vorgesehen ist. Für die Orientierung der Transistoren T1 und T3 hinsichtlich des Abstandes ihrer Gateelektroden von dem Schaltungseingang E1 ergibt sich dabei, daß die Gateelektrode von T1, gemessen auf der Gateleitung 9, dem Schaltungseingang E1 näher liegt als die Gateelektrode von T3. Tritt hierbei ein Unterbrechungsfehler in dem zwischen T1 und T3 liegenden Teil der Gateleitung 9 auf, so wirkt sich dieser nur noch auf T3 aus, d.h. auf einen Transistor, der im Serienzweig der Gatterschaltung nach Fig. 1 liegt. Ein solcher Unterbrechungsfehler ist aber in der Fehlererkennung relativ einfach zu behandeln. Ein Unterbrechungsfehler in de zwischen E1 und T1 liegenden Teil der Gateleitung betrifft zwar die Funktionsfähigkeit beider Transistoren T1 und T3, wird aber als Haftfehler am Gattereingang gewertet und kann deshalb auf sehr einfache Weise erkannt werden. Damit reduziert sich der Testaufwand bei einer Schaltung nach Fig. 3 im Vergleich zu einer Schaltung nach Fig. 2 weiterhin sehr wesentlich. Die gleiche Aufwandsreduktion wird auch hinsichtlich einer Überprüfung der Gateleitung 10 auf das Vorliegen eines Unterbrechungsfehlers erreicht.

Die Gateleitungen 9 bzw. 10 können mit Vorteil als zwei Schichtenleitungen ausgebildet sein, wobei eine Teilschicht aus polykristallinem Silizium besteht, während die andere z.B. aus einem Silizid gebildet ist.

Bezugszeichenliste

| 1 | Anschluß |
|---|---|
| 2 | Schaltungspunkt |
| 3 | Anschluß |
| 4 | Halbleiterkörper |
| 5 | Wanne |
| 6a, b, c | Zonen |
| 7, 8 | Teilgebiete von 4 |
| 9, 10 | polykristalline Streifen |
| 11, 12 | leitende Belegungen |
| 12a | Kontaktloch |
| 14a, b, c | Zonen |
| 15, 16 | Teilgebiete von 5 |
| 17, 18, 19 | Kontaktlöcher |
| 20 | leitende Belegung |
| T1...T4 | Feldeffekttransistoren |
| A | Gatterausgang |
| E1, E2 | Schaltungsausgänge |

## Ansprüche

1. Logikschaltung mit einer Mehrzahl von auf einem dotierten Halbleiterkörper (4) integrierten, zueinander komplementären Feldeffekttransistoren, bei der über wenigstens einen Schaltungseingang (E1) jeweils zwei oder mehrere zueinander komplementäre Feldeffekttransistoren (T3, T1) mit demselben Eingangssignal angesteuert werden, **dadurch gekennzeichnet,** daß an wenigstens einem der Schaltungseingänge (E1) eine von diesem ausgehende, verzweigungsfrei ausgebildete, auf dem Halbleiterkörper angeordnete und durch wenigstens eine elektrisch isolierende Schicht von diesem getrennte Gateleitung (9) vorgesehen ist, daß die Gateleitung (9) für zwei oder mehrere über diesen Eingang anzusteuernde Feldeffekttransistoren (t3, T1) gemeinsam ist und daß die Gateelektroden der letzteren durch im Abstand voneinander angeordnete Abschnitte der Gateleitung (9) gebildet werden.

2. Logikschaltung nach Anspruch 1, **dadurch gekennzeichnet,** daß bei zwei zueinander komplementären Feldeffekttransistoren (T3, T1), die über einen Schaltungseingang (E1) anzusteuern sind, der erste (T1) mit seiner Source-Drain-Strecke der Source-Drain-Strecke eines anderen Feldeffekttransistors (T2) parallel geschaltet ist, daß der zweite (T3) zu einem weiteren Feldeffektransistor (T4) unmittelbar in Serie liegt und daß die Gateelektroden des ersten (T1) und des zweiten Feldeffekttransistors (T3) derart zueinander und zu dem mit dem Schaltungseingang (E1) verbundenen Anfang der für beide Feldeffekttransistoren gemeinsamen Gateleitung (9) orientiert sind, daß der die Gateelektrode des ersten Feldeffekttransistors (T1) bildende Abschnitt der Gateleitung (9) dem Anfang derselben näher liegt als der die Gateelektrode des zweiten Feldeffekttransistors (T3) bildende Abschnitt.

3. Logikschaltung nach Anspruch 1 oder 2, **daurch gekennzeichnet,** daß die die Gateelektroden bildenden Abschnitte der Gateleitung (9) aus einer Schicht bestehen, die zumindest teilweise aus polykristallinem Silizium besteht, wobei insbesondere eine Teilschicht aus polykristallinem Silizium vorgesehen ist, die durch eine weitere Teilschicht aus einem Silizid zu der genannten Schicht ergänzt ist.

# FIG 1

# FIG 2

# FIG 3